# EUROPEAN PATENT SPECIFICATION

(11) **EP 2 450 968 B1**
(45) Date of publication and mention of the grant of the patent: **31.07.2019**
(21) Application number: 10794366.4
(22) Date of filing: 30.06.2010
(51) Int. Cl.: H01L 31/05, H01L 31/042, H01L 27/142, H01L 31/0224, H01L 31/02, H01L 31/0463

(54) **SOLAR PHOTOVOLTAIC DEVICE**
PHOTOVOLTAIKVORRICHTUNG
DISPOSITIF PHOTOVOLTAÏQUE

(30) Priority: 30.06.2009 KR 20090058900
(43) Date of publication of application: 09.05.2012
(73) Proprietor: LG Innotek Co., Ltd., Seoul, 04637 (KR)
(72) Inventor: JEE, Suk Jae, Seoul 100-714 (KR)
(74) Representative: Novagraaf Technologies
(86) International application number: PCT/KR2010/004257
(87) International publication number: WO 2011/002231

(56) References cited:
- EP-A1- 2 040 313
- EP-A1- 2 065 947
- JP-A- 2007 234 795
- JP-A- 2009 111 034
- KR-A- 20050 102 854
- KR-A- 20060 116 451
- KR-B1- 100 654 103
- KR-U- 20090 003 860
- US-A- 5 865 904
- US-A1- 2007 251 566

## Description

### [Technical Field]

Embodiments relate to a solar cell apparatus.

### [Background Art]

As the demand of energy increases in recent years, solar cells that convert solar energy into electrical energy are being developed.

In particular, each of the solar cells includes a plurality of layers such as a glass substrate, a metal backside electrode layer, a P-type CIGS-based light absorption layer, a high resistance buffer layer, and an N-type window layer.

Also, the solar cells have a structure in which the cells are connected to each other in parallel or in series.

EP2040313 discloses a panel-shaped light receiving or emitting semiconductor module comprising multiple rod-shaped semiconductor elements.

### [Disclosure]

### [Technical Problem]

Embodiments provide a solar cell apparatus which reduces current loss, has a simple structure, and includes cells connected to each other in parallel.

### [Technical Solution]

The invention is defined in claim 1.

### [Advantageous Effects]

In the solar cell apparatus according to the embodiments, the first bus bar is disposed at the central portion, and the cells are disposed on both sides of the first bus bar. Also, in the solar cell apparatus according to the embodiments, the second bus bar and the third bus bar are disposed on both ends of the substrate.

Thus, the cells disposed on both sides of the first bus bar are connected to each other in parallel. Here, the current generated by the solar energy moves from both ends to the first bus bar disposed at the central portion or from the first bus bar disposed at the central portion to the second bus bar and the third bus bar, which are disposed on both ends.

Thus, in the solar cell apparatus according to an embodiment, the electrons move a relatively short distance when compared to a solar cell in which electrons move from one end to the other end.

Thus, the solar cell apparatus according to an embodiment has improved efficiency.

Also, in the solar cell apparatus according to an embodiment, the electrons move in directions opposite to each other using the first bus bar disposed at the central portion.

Thus, in the solar cell apparatus according to an embodiment, the cells connected in series are also connected in parallel.

### [Description of Drawings]

Fig. 1 is a plan view of a solar cell apparatus according to an embodiment.
Fig. 2 is a circuit view of a solar cell apparatus according to an embodiment.
Fig. 3 is a sectional view taken along line A-A' of Fig. 1.

### [Mode for Invention]

In the description of embodiments, it will understood that when a layer, film, electrode, groove, member, bar or layer is referred to as being 'on' another layer (or film), region, pad or pattern, the terminology of 'on' and 'under' includes both the meanings of 'directly' and 'indirectly'. Further, the reference about 'on' and 'under' each layer will be made on the basis of drawings. In the drawings, the thickness or size of each layer is exaggerated for convenience in description and clarity. Also, the size of each element does not entirely reflect an actual size.

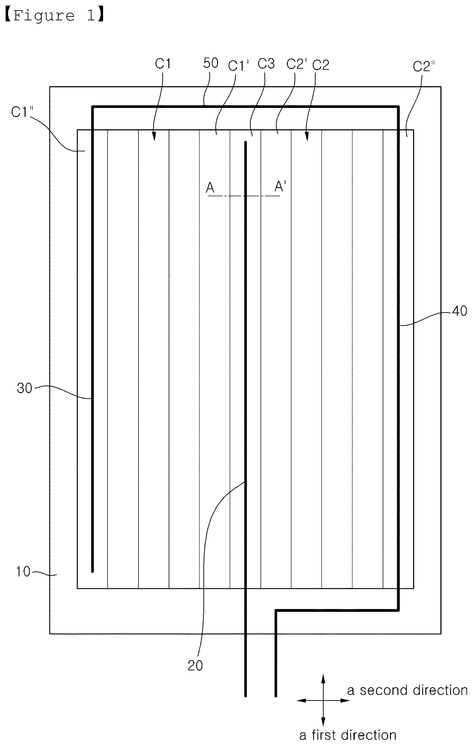

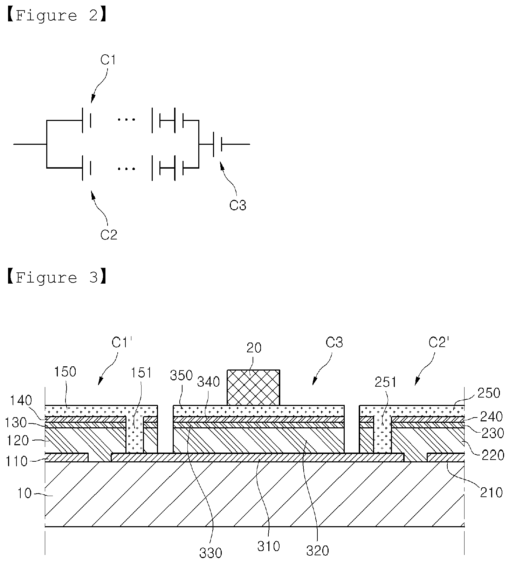

Fig. 1 is a plan view of a solar cell apparatus according to an embodiment. Fig. 2 is a circuit view of a solar cell apparatus according to an embodiment. Fig. 3 is a sectional view taken along line A-A' of Fig. 1.

Referring to Figs. 1 to 3, a solar cell apparatus according to an embodiment includes a support substrate 10, a plurality of first cells C1, a plurality of second cells C2, a third cell C3, a first bus bar 20, a second bus bar 30, a third bus bar 40, and a connection part 50.

The support substrate 10 has a plate shape. The support substrate 10 supports the first cells C1, the second cells C2, the third cell C3, the first to third bus bars 20, 30, and 40, and the connection part 50.

The support substrate 10 may be a glass substrate, a plastic substrate, or a metal substrate. In further detail, the support substrate 10 may be a soda-lime glass substrate.

The first cells C1 are disposed on the support substrate 10. The first cells C1 are connected to each other in series. The first cells C1 has a shape extending in a first direction. That is, the first cells C1 are disposed alongside with each other. The first cells C1 may be disposed parallel to each other.

The first cells C1 are disposed between the first bus bar 20 and the second bus bar 30 when viewed in a plan view.

Referring to Fig. 3, each of the first cells C1 includes a first backside electrode 110, a first light absorption part 120, a first buffer 130, a first high resistance buffer 140, and a first window 150.

The first backside electrode 110 is disposed on the support substrate 10. The first backside electrode 110 may be a conductor. Examples of materials used for the first backside electrode 110 may include molybdenum, etc.

The first light absorption part 120 is disposed on the first backside electrode 110. The first light absorption part 120 may include group I-III-VI compounds. For example, the first light absorption part 120 may have a copper indium gallium selenide (Cu(In,Ga)Se₂; CIGS) crystal structure, a copper indium selenide crystal structure, or a copper gallium selenide crystal structure.

The first light absorption part 120 may have an energy band gap of about 1eV to about 1.8eV.

The first buffer 130 is disposed on the first light absorption part 120. Examples of materials used for the first buffer 130 may include cadmium sulfide, etc.

The first high resistance buffer 140 is disposed on the first buffer 130. Examples of materials used for the first high resistance buffer 140 may include undoped zinc oxide, etc.

The first window 150 is disposed on the first high resistance buffer 140. Examples of materials used for the first window 150 may be undoped zinc oxide, etc.

The second cells C2 is disposed on the support substrate 10. The second cells C2 are disposed in a region adjacent to a region in which the first cells C1. When viewed in a plan view, the second cells C2 is disposed between the first bus bar 20 and the third bus bar 40.

The second cells C2 are connected to each other in series. The second cells C2 may have a shape extending in the first direction. That is, the second cells C2 extend in the first direction. The second cells C2 are disposed alongside with each other. The second cells C2 may be disposed parallel to each other.

That is, when viewed in a plan view, the first cells C1 and the second cells C2 are disposed on positions opposite to each other with the first bus bar 20 therebetween.

Referring to Fig. 3, each of the second cells C1 includes a second backside electrode 210, a second light absorption part 220, a second buffer 230, a second high resistance buffer 240, and a second window 250.

The second backside electrode 210 is disposed on the support substrate 10. The second backside electrode 210 may be a conductor. Examples of materials used for the second backside electrode 210 may include molybdenum, etc.

The second light absorption part 220 is disposed on the second backside electrode 210. The second light absorption part 220 may include group I-III-VI compounds. The second light absorption part 220 may have an energy band gap of about 1eV to about 1.8eV.

The second buffer 230 is disposed on the second light absorption part 220. Examples of materials used for the second buffer 230 may include cadmium sulfide, etc.

The second high resistance buffer 240 is disposed on the second buffer 230. Examples of materials used for the second high resistance buffer 240 may include undoped zinc oxide, etc.

The second window 250 is disposed on the second high resistance buffer 240. Examples of materials used for the second window 250 may be intrinsic zinc oxide(iZO), etc.

The third cell C3 is disposed on the support substrate 10. Also, the third cell C3 is disposed between the support substrate 10 and the first bus bar 20.

The third cell C3 is disposed between the first cells C1 and the second cells C2. Similarly, when viewed in a plan view, the first cells C1 and the second cells C2 are disposed on positions opposite to each other with the third cell C3 therebetween.

The third cell C3 is disposed in a region between a region in which the first cells C1 are disposed and a region in which the second cells C2 are disposed. The third cell C3 has a shape longitudinally extending in the first direction.

The third cell C3 is connected to the first cells C1 and the second cells C2. In detail, the third cell C3 is electrically connected to the first cells C1 and the second cells C2. In further detail, the third cell C3 is connected to a first cell C1' most adjacent to the third cell C3 and a second cell C2' most adjacent to the third cell C3.

Also, the third cell C3 is connected to the first bus bar 20. The third cell C3 may directly contact the first bus bar 20. The third cell C3 is electrically connected to the first bus bar 20.

Referring to Fig. 3, the third cell C3 includes a third backside electrode 310, a third light absorption part 320, a third buffer 330, a third high resistance buffer 340, and a third window 350.

The third backside electrode 310 is disposed on the support substrate 10. The third backside electrode 310 may be a conductor. Examples of materials used for the third backside electrode 310 may include molybdenum, etc.

The third light absorption part 320 is disposed on the third backside electrode 310. The third light absorption part 320 may include group I-III-VI compounds. The third light absorption part 320 may have an energy band gap of about 1eV to about 1.8eV.

The third buffer 330 is disposed on the third light absorption part 320. Examples of materials used for the third buffer 330 may include cadmium sulfide, etc.

The third high resistance buffer 340 is disposed on the third buffer 330. Examples of materials used for the third high resistance buffer 340 may include undoped zinc oxide, etc.

The third window 350 is disposed on the third high resistance buffer 340. Examples of materials used for the third window 350 may include zinc oxide doped with aluminum.

Also, the third backside electrode 310 is connected to the first window 150 of the first cell C1' adjacent thereto. In further detail, the third backside electrode 310 is connected to a first connection electrode 151 extending from the first window 150 of the first cell Cl' adjacent thereto.

Also, the third backside electrode 310 is connected to the second window of the second cell C2' adjacent thereto. In further detail, the third backside electrode 310 is connected to a second connection electrode 251 extending from the second window 250 of the second cell C2' adjacent thereto.

As a result, the third cell C3 is connected to the first cells C1 in series, and simultaneously, connected to the second cells C2 in series.

The third cell C3 has a plane area greater than a mean area of the first cells C1 and a mean area of the second cells C2. In further detail, the third cell C3 has the plane area greater than the sum of the mean area of the first cells C1 and the mean area of the second cells C2.

An effective area (the plane area of the third cell C3 except an area in which the first bus bar is covered) of the third cell C3 is substantially equal to the sum of a plane area of each of the first cells C1 and a plane area of each of the second cells C2.

As a result, a current amount of the third cell C3 is equal to or greater than the sum of a current amount of each of the first cells C1 and a current amount of each of the second cells C2.

Thus, an output of the entire solar cell apparatus is not be deteriorated by the third cell C3.

The first bus bar 20 is disposed at a central portion of the support substrate 10. For example, the first bus bar 20 may be disposed at a center of the support substrate 10.

The first bus bar 20 is disposed on the third cell C3. The first bus bar 20 is disposed between the first cells C1 and the second cells C2. The first bus bar 20 is disposed in a region between the region in which the first cells C1 are disposed and the region in which the second cells C2 are disposed.

The first bus bar 20 is connected to the third cell C3. The first bus bar 20 is electrically connected to the third cell C3. The first bus bar 20 contacts the third cell C3. In further detail, the first bus bar 20 may directly contact the third cell C3.

Also, the first bus bar 20 is connected to the third window 350. The first bus bar 20 is electrically connected to the third window 350. The first bus bar 20 contacts the third window 350. In further detail, the first bus bar 20 may directly contact the third window 350.

The first bus bar 20 is electrically connected to the first cells C1 and the second cells C2 through the third cell C3.

The first bus bar 20 extends corresponding to the third cell C3. The first bus bar 20 extends in the first direction.

The second bus bar 30 is disposed on an edge of the support substrate 10. Also, the second bus bar 30 is disposed on one of the first cells C1. In further detail, the second bus bar 30 is disposed on a first outermost cell C1".

Also, the second bus bar 30 is connected to the first cells C1. In further detail, the second bus bar 30 is electrically connected to the first cells C1. In further detail, the second bus bar 30 directly contacts the first outermost cell C1". That is, the second bus bar 30 directly contacts the first window of the first outermost cell C1" and is electrically connected to the first cells C1.

The third bus bar 40 is connected to the second cells C2. In further detail, the third bus bar 40 is electrically connected to the second cells C2. In further detail, the third bus bar 40 directly contacts the second outermost cell C2". That is, the third bus bar 40 directly contacts the second window of the second outermost cell C2" and is electrically connected to the second cells C2.

The connection part 50 connects the second bus bar 30 to the third bus bar 40. The connection part 50 is disposed in an inactive region in which the first cells C1, the second cells C2, and the third cell C3 are not disposed.

The connection part 50 may be integrated with the second bus bar 30 and the third bus bar 40.

The first to third bus bars 20, 30, and 40 and the connection part 50 are realized as a conductor. For example, the first to third bus bars 20, 30, and 40 and the connection part 50 may be conductive tape. Examples of materials used for the first to third bus bars 20, 30, and 40 and the connection part 50 may include copper, silver, or aluminum.

Electrons generated in the first cells C1 move from the outside to the first bus bar 20. That is, the electrons generated from the first cells C1 move from the second bus bar 30 to the first bus bar 20 in the second direction substantially perpendicular to the first direction. That is, current generated from the first cells C1 flows from a central portion to the outside.

Similarly, electrons generated in the second cells C2 move from the outside to the first bus bar 20. That is, the electrons generated from the second cells C2 from the third bus bar 40 to the first bus bar 20 in the second direction substantially perpendicular to the first direction. That is, current generated from the second cells C2 flows from a central portion to the outside.

That is, in the solar cell apparatus according to an embodiment, the generated electrons move from the outside to the first bus bar 20 that is disposed at the central portion.

Thus, in the solar cell apparatus according to an embodiment, the electrons move a relatively short distance when compared to a solar cell in which electrons move from one end to the other end.

Thus, the solar cell apparatus according to an embodiment has improved efficiency.

Also, in the solar cell apparatus according to an embodiment, the electrons move in directions opposite to each other using the first bus bar 20 disposed at the central portion.

Thus, in the solar cell apparatus according to an embodiment, the cells connected in series are also connected in parallel. That is, in the solar cell apparatus according to an embodiment, the first cells C1 and the second cells C2 are disposed along one line in the second direction.

## Claims

1. A solar cell apparatus comprising:
a substrate (10);
a plurality of first solar cells (C1) disposed on the substrate (10);
a plurality of second solar cells (C2) disposed on the substrate (10); and
a first bus bar (20) disposed between the first solar cells (C1) and the second solar cells (C2), wherein the first bus bar (20) is connected to the first solar cells (C1) and the second solar cells (C2),
the solar cell apparatus further comprises a third solar cell (C3) disposed between the first solar cells (C1) and the second solar cells (C2) on the substrate (10), wherein the first bus bar (20) is disposed on the third solar cell (C3) and is electrically connected to the third solar cell;
wherein the first bus bar (20) is connected to the first solar cells (C1) and the second solar cells (C2) through the third solar cell (C3);
wherein the first solar cells (C1) are connected to each other in series between the third solar cell (C3) and a second bus bar (30) connected to an outermost of the first solar cells (C1);
wherein the second solar cells (C2) are connected to each other in series between the third solar cell (C3) and a third bus bar (40) connected to an outermost of the second solar cells (C2);
a connection part (50) connecting the second bus bar (30) to the third bus bar (40);
**characterized in that** the third solar cell (C3) has a plane area greater than the sum of a mean area of the first solar cells and a mean area of the second solar cells.

## Patentansprüche

1. Solarzelleneinrichtung, umfassend:
ein Substrat (10);
eine Vielzahl von ersten Solarzellen (C1), die an dem Substrat (10) angeordnet sind;
eine Vielzahl von zweiten Solarzellen (C2), die an dem Substrat (10) angeordnet sind; und
eine erste Sammelschiene (20), die zwischen den ersten Solarzellen (C1) und den zweiten Solarzellen (C2) angeordnet ist, wobei die erste Sammelschiene (20) mit den ersten Solarzellen (C1) und den zweiten Solarzellen (C2) verbunden ist,
die Solarzelleneinrichtung umfasst weiter eine dritte Solarzelle (C3), die zwischen den ersten Solarzellen (C1) und den zweiten Solarzellen (C2) an dem Substrat (10) angeordnet ist, wobei die erste Sammelschiene (20) an der dritten Solarzelle (C3) angeordnet ist und elektrisch mit der dritten Solarzelle verbunden ist;
wobei die erste Sammelschiene (20) mit den ersten Solarzellen (C1) und den zweiten Solarzellen (C2) durch die dritte Solarzelle (C3) verbunden ist;
wobei die ersten Solarzellen (C1) miteinander in Reihe zwischen der dritten Solarzelle (C3) und einer zweiten Sammelschiene (30) verbunden sind, die mit einer äußersten der ersten Solarzellen (C1) verbunden ist;
wobei die zweiten Solarzellen (C2) miteinander in Reihe zwischen der dritten Solarzelle (C3) und einer dritten Sammelschiene (40) verbunden sind, die mit einer äußersten der zweiten Solarzellen (C2) verbunden ist;
wobei ein Verbindungsteil (50) die zweite Sammelschiene (30) mit der dritten Sammelschiene (40) verbindet;
**dadurch gekennzeichnet, dass** die dritte Solarzelle (C3) eine ebene Fläche größer als die Summe einer mittleren Fläche der ersten Solarzellen und einer mittleren Fläche der zweiten Solarzellen aufweist.

## Revendications

1. Appareil de cellule solaire comprenant :
un substrat (10) ;
une pluralité de premières cellules solaires (C1) disposées sur le substrat (10) ;
une pluralité de deuxièmes cellules solaires (C2) disposées sur le substrat (10) ; et
une première barre omnibus (20) disposée entre les premières cellules solaires (C1) et les deuxièmes cellules solaires (C2), dans lequel la première barre omnibus (20) est connectée aux premières cellules solaires (C1) et aux deuxièmes cellules solaires (C2),
l'appareil de cellule solaire comprend en outre une troisième cellule solaire (C3) disposée entre les premières cellules solaires (C1) et les deuxièmes cellules solaires (C2) sur le substrat (10), dans lequel la première barre omnibus (20) est disposée sur la troisième cellule solaire (C3) et est électriquement connectée à la troisième cellule solaire ;
dans lequel la première barre omnibus (20) est connectée aux premières cellules solaires (C1) et aux deuxièmes cellules solaires (C2) par le biais de la troisième cellule solaire (C3) ;
dans lequel les premières cellules solaires (C1) sont connectées les unes aux autres en série entre la troisième cellule solaire (C3) et une deuxième barre omnibus (30) connectée à une plus externe des premières cellules solaires (C1) ;
dans lequel les deuxièmes cellules solaires (C2) sont connectées les unes aux autres en série entre la troisième cellule solaire (C3) et une troisième barre omnibus (40) connectée à une plus externe des deuxièmes cellules solaires (C2) ;
une partie de connexion (50) connectant la deuxième barre omnibus (30) à la troisième barre omnibus (40) ;
**caractérisé en ce que** la troisième cellule solaire (C3) a une aire de plan plus grande que la somme d'une aire moyenne des premières cellules solaires et d'une aire moyenne des deuxièmes cellules solaires.
